(19) Europäisches Patentamt European Patent Office Office européen des brevets

(11) **EP 4 332 602 B1**

(12) **EUROPÄISCHE PATENTSCHRIFT**

(45) Veröffentlichungstag und Bekanntmachung des Hinweises auf die Patenterteilung:
**21.05.2025   Patentblatt 2025/21**

(21) Anmeldenummer: **22193093.6**

(22) Anmeldetag: **31.08.2022**

(51) Internationale Patentklassifikation (IPC):
**G01R 33/561** (2006.01)     **G01R 33/565** (2006.01)

(52) Gemeinsame Patentklassifikation (CPC):
**G01R 33/5614; G01R 33/56527; G01R 33/56536; G01R 33/56563**

(54) **VERFAHREN ZUR ERFASSUNG VON MAGNETRESONANZ-BILDDATEN UND MAGNETRESONANZVORRICHTUNG**

METHOD FOR ACQUIRING MAGNETIC RESONANCE IMAGE DATA, AND MAGNETIC RESONANCE APPARATUS

PROCÉDÉ D'ACQUISITION DE DONNÉES D'IMAGE PAR RÉSONANCE MAGNÉTIQUE ET APPAREIL DE RÉSONANCE MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**06.03.2024   Patentblatt 2024/10**

(73) Patentinhaber: **Siemens Healthineers AG**
**91301 Forchheim (DE)**

(72) Erfinder:
• **Faust, Jonas**
**71229 Leonberg (DE)**
• **Speier, Peter**
**91056 Erlangen (DE)**
• **Maier, Florian**
**91054 Buckenhof (DE)**

(74) Vertreter: **Siemens Healthineers**
**Patent Attorneys**
**Postfach 22 16 34**
**80506 München (DE)**

(56) Entgegenhaltungen:
• **IOANNIS KOKTZOGLOU ET AL: "Dephased FLAPS for improved visualization of susceptibility-shifted passive devices for real-time interventional MRI; Dephased FLAPS", PHYSICS IN MEDICINE AND BIOLOGY, INSTITUTE OF PHYSICS PUBLISHING, BRISTOL GB, vol. 52, no. 13, 7 July 2007 (2007-07-07), pages N277 - N286, XP020112956, ISSN: 0031-9155, DOI: 10.1088/0031-9155/52/13/N01**
• **WEINE J. ET AL.: "Interleaved White Marker Contrast with bSSFP Real-Time Imaging for Deep Learning based Needle Localization in MR-Guided Percutaneous Interventions", PROCEEDINGS OF THE INTERNATIONAL SOCIETY FOR MAGNETIC RESONANCE IN MEDICINE, 27TH ANNUAL MEETING, no. 3832, 26 April 2019 (2019-04-26), Canada, XP040711217**
• **SUNIL PATIL ET AL: "Echo-dephased steady state free precession", MAGNETIC RESONANCE MATERIALS IN PHYSICS, BIOLOGY AND MEDICINE, CHAPMAN AND HALL, LONDON, GB, vol. 22, no. 5, 16 May 2009 (2009-05-16), pages 277 - 285, XP019744854, ISSN: 1352-8661, DOI: 10.1007/S10334-009-0173-3**

**Beschreibung**

Die vorliegende Erfindung betrifft ein Verfahren zur Erfassung von Magnetresonanz-Bilddaten eines Untersuchungsobjekts durch eine Magnetresonanzvorrichtung. Die Erfindung ist ferner auf eine entsprechende Magnetresonanzvorrichtung gerichtet.

Magnetresonanzvorrichtungen sind bildgebende Vorrichtungen, die ein starkes äußeres Magnetfeld nutzen, um die Kernspins eines zu untersuchenden Objekts auszurichten und sie durch Anlegen eines HF-Anregungspulses zur Präzession um die entsprechende Ausrichtung anzuregen. Die Präzession beziehungsweise der Übergang der Spins von diesem angeregten Zustand in einen Zustand mit geringerer Energie erzeugt als Antwort ein elektromagnetisches Wechselfeld, das über Empfangsantennen als MR-Signal detektiert werden kann.

Mit Hilfe von magnetischen Gradientenfeldern kann den Signalen eine Positionskodierung aufgeprägt werden, die es anschließend erlaubt, das erhaltene Signal einem Volumenelement des Untersuchungsobjekts zuzuordnen. Das empfangene Signal kann dann ausgewertet werden, um beispielsweise eine Bilddarstellung des Untersuchungsobjekts bereitzustellen.

Objekte, beispielsweise aus paramagnetischem Stoff, die sich in dem Untersuchungsobjekt befinden, können aufgrund einer von einem umgebenden Stoff abweichenden magnetischen Suszeptibilität ein Magnetfeld in einer Umgebung um das Objekt verändern. Dadurch kann das Magnetfeld in einer Umgebung des Objekts lokale, durch das Objekt hervorgerufene magnetische Feldgradienten aufweisen. Aufgrund der Feldgradienten kann es in der Umgebung um das Objekt zu unterschiedlichen lokalen Phasenveränderungen währen einer Repetitionszeit kommen. Die lokal induzierten Feldinhomogenitäten können dazu führen, dass Protonen innerhalb eines Volumenelements eines Voxels gegenphasig magnetisiert sind, wodurch es zu einer Signalabschwächung eines dem Voxel zugeordneten Signals kommen kann. Um die Signalabschwächung zumindest reduzieren zu können, ist es verbreitet, während der Sequenz einen zusätzlichen Gradienten bereitzustellen, um die durch das magnetfeldverändernde Objekt in dem Untersuchungsobjekt hervorgerufene Dephasierung zumindest teilweise auszugleichen. Dieser Gradient wird auch als so genannter Whitemarker-Gradient bezeichnet. Durch die Bereitstellung des Whitemarker-Gradienten können magnetfeldverändernde Objekte sichtbar gemacht werden. Das Gewebe in unmittelbarer Umgebung der Objekte erzeugt Signale, die in der Bildgebung intensitätsstarke Bildbereiche, sogenannte Artefakte, hervorrufen. Die Artefakte heben sich aufgrund ihrer Intensität von der Umgebung ab. Die Umgebung, welche sich durch ein homogenes Magnetfeld auszeichnet, wird dabei durch den Whitemarker-Gradienten dephasiert. Diese Bereitstellung eines Whitemarker-Gradienten wird auch als dephasierte Magnetresonanzbilderzeugung bezeichnet. Whitemarker-Gradienten können beispielsweise bei Gradientenechosequenzen verwendet werden. Ein Whitemarker-Kontrast kann durch das Bereitstellen eines Extra-Gradienten erzeugt werden, oder auch durch ein Weglassen, Vermindern und/oder Variieren von für die Sequenz typischen Rephasiergradienten. Der Rephasiergradient kann beispielsweise ein Rephasierer eines Schichtwahlgradienten sein, wie es in Seppenwoolde et al (2003), (SEPPENWOOLDE, Jan-Henry; VIERGEVER, Max A.; BAKKER, Chris JG. Passive tracking exploiting local signal conservation: the white marker phenomenon. Magnetic Resonance in Medicine: An Official Journal of the International Society for Magnetic Resonance in Medicine, 2003, 50. Jg., Nr. 4, S. 784-790.) beschrieben ist. In Spin-Echosequenzen ist es nicht möglich, Signalstärken durch den Whitemarker-Gradienten zu erhöhen. Der Grund dafür ist, dass aufgrund der Anregung des Untersuchungsobjekts zur Phasenänderung um 180 Grad die durch den Whitemarker-Gradient die lokalen Feldinhomogenitäten eingeführte Dephasierung rückgängig gemacht werden würde. Bei Spin-Echosequenzen, ergibt sich kein Artefakt, was rephasiert werden könnte, da die Dephasierung durch die Feldinhomogenitäten um das Objekt bereits durch den 180 Grad Puls ausgeglichen wird.

Eine besondere Form einer Sequenz ist eine Balanced Steady-State Free Precession Sequence, kurz bSSFP. Dabei ist es vorgesehen, dass wie bei Gradientenechosequenzen (GRE) magnetische Feldgradienten bereitgestellt werden, um Echosignale zu erzeugen. Diese werden jedoch während einer Repetitionszeit (TR) ausbalanciert. In der Nähe des magnetfeldverändernden Objektes kann es, wie bei den Gradientenechosequenzen, aufgrund lokaler Feldinhomogenitäten zur Signalauslöschung kommen. Die besondere Signalentstehung in der bSSFP kann hier zu einer alternierenden Phase zum Echozeitpunkt TE in einem Voxel führen, wobei dies eine destruktive Interferenz der Spins hervorruft. Die besonderer Signalentstehung bei der bSSFP-Bildgebung hat eine Rephasierung der Spins zum Zeitpunkt TE=TR/2 zur Folge, welche die Dephasierung durch lokale Feldinhomogenitäten ausgleicht. Die bSSFP Sequenz kann deshalb auch als "Spin-Echo ähnliche" Sequenz beschrieben werden. Der entscheidende Unterschied ist allerdings, dass die Phase zu der die Spins rephasieren abhängig ist vom Phasenfortschritt der selbigen im Zeitraum TR, also dem Zeitraum zwischen zwei Anregungspulsen. Liegt dieser zwischen $(2n-1)*pi$ und $(2n)*pi$ wobei $n$ eine natürliche Zahl ist, so rephasieren die Spins mit entgegengesetzter Phase zu den Spins mit einem Phasenfortschritt zwischen $(2n)*pi$ und $(2n+1)*pi$, wobei $n$ eine natürliche Zahl inklusive der Null ist. Durch die starken lokalen Feldgradienten in unmittelbarer Nähe eines magnetfeldverändernden Objektes, welche zu einer örtlich variierenden ackumulierten Spinphase während TR führt, können die Spins innerhalb eines Voxels zum Zeitpunkt TE mit alternierender Phase rephasieren und die Signale destruktiv interferieren. Diese Signalabschwächung kann, wie bei Gradientenechosequenzen, durch einen Whitemarker-Gradienten teilweise ausgeglichen werden.

Das Verwenden eines Whitemarker-Gradienten kann ungewollt erhöhte Signalintensitäten an Grenzflächen unterschiedlicher Stoffe hervorrufen. Dies tritt beispielsweise an Grenzflächen zwischen Fett und anderem Gewebe auf. Die erhöhten Signalintensitäten sind auf unterschiedliche Resonanzfrequenzen der Protonen in Wasser des Gewebes und der Protonen des Fetts zurückzuführen. Der Frequenzunterschied zwischen der Resonanzfrequenz der Protonen in Wasser und der Resonanzfrequenz der Protonen in Fett beträgt 225 Hz bei einer äußeren Feldstärke von 1,5 Tesla. Befinden sich die Wasserprotonen und die Fettprotonen in dem gleichen Volumenelement, führt die Abweichung zwischen den Resonanzfrequenzen zu einer Phasendifferenz zwischen den Wasserprotonen und den Fettprotonen, nachdem die Protonen ausgelenkt wurden.

Zu Beginn der Auslenkung der Magnetisierung aus der Longitudinalen in die Transversale und der transversalen Relaxation befinden sich die Wasserprotonen und die Fettprotonen in Phase. Aufgrund der unterschiedlichen Resonanzfrequenzen ändert sich die Phase der Wasserprotonen stärker als die Phase der Fettprotonen. Dadurch sind die beiden Protonengruppen außer Phase und bei einer Magnetfeldstärke von beispielsweise 1,5 Tesla nach einer ersten Echozeit von 2,2 msec nach der Anregung entgegengesetzt ausgerichtet. Aufgrund der entgegengesetzten Ausrichtung der Protonen in dem Volumenelement kommt es zu einer destruktiven Überlagerung der jeweiligen Signale, wodurch das resultierende Signal des Volumenelements zu der ersten Echozeit eine schwache Intensität aufweist. Nach einer zweiten Echozeit von 4,4 msec beträgt die Differenz der Phasen zwischen den Wasserprotonen und den Fettprotonen 0 Grad, so dass beide Protonengruppen in Phase sind. Dadurch kommt es zu einer konstruktiven Überlagerung, wodurch die Intensität des Signals des Volumenelements erhöht ist. In der Gradientenecho-Bildgebung führt dies dazu, dass das Signal zu der ersten Echozeit aufgehoben, beziehungsweise geschwächt wird und das Signal bei der zweiten Echozeit konstruktiv überlagert wird und sich die Intensitäten addieren. Ebenfalls kann es in bSSFP Sequenzen zu einer Auslöschung an Grenzflächen kommen. Nach der Ausbildung des Steady-States bei der bSSFP nach mehreren TRs sind die Wasser- und Fettprotonen nicht mehr in Phase zu Beginn von TR. Je nach Ausgestaltung der Sequenz (Wahl der Repetitionszeit) können diese zum Zeitpunkt TE=TR/2 entgegengesetzte Phase haben, da diese, wie oben beschrieben je nach der während TR akkumulierten Phase, entweder 0 oder 180 Grad beträgt. Sind also die Spins zweier Materialien an Grenzflächen zum Echozeitpunkt außer Phase, so kann die Verwendung eines Whitemarker-Gradienten diese wieder teilweise in Phase bringen und so Signalintensität generieren.

Der zusätzliche Whitemarker-Gradient führt dazu, dass eine Magnetisierung im Gewebe eines homogenen magnetischen Feldes dephasiert wird. Die Dephasierung in inhomogenen Bereichen wird jedoch durch den Whitemarker-Gradienten reduziert. Dies führt dazu, dass Gewebebereiche eines homogenen magnetischen Feldes in ihrer Intensität reduziert werden und gleichzeitig Gewebebereiche eines inhomogenen magnetischen Feldes in ihrer Intensität erhöht werden.

Bei einer Bereitstellung eines Whitemarker-Gradienten kommt es, wie oben beschrieben, zu einer weiteren Veränderung der Signalintensität an den Grenzflächen. Bei einer Bereitstellung des Whitemarker-Gradienten in der Sequenz kann es bei einer Anwesenheit eines Fettgewebes dazu kommen, dass die Signalintensität an Volumenelementen an der Grenzfläche zwischen Fettgewebe und weiterem Gewebe zunimmt. Dadurch wird nicht nur die Signalintensität in der Umgebung des magnetfeldverändernden Objekts erhöhte, sondern auch die Signalintensität entlang der Grenzflächen. Dies kann jedoch unerwünscht sein, wenn in der Bildgebung eine hervorgehobene Darstellung des magnetfeldverändernden Objektes vorgesehen ist und eine erhöhte Signalintensität an Grenzflächen unerwünscht ist.

Ein beispielhaftes bSSFP-Verfahren ist aus dem Artikel von Koktzoglou et al., "Dephased FLAPS for improved visualization of susceptibility-shifted passive devices for real-time interventional MRI", Physics in Medicine and Biology, Bd. 52, Nr. 13, 2007, Seiten N277-N286, bekannt.

Es ist somit eine Aufgabe der Erfindung, eine Signalintensität an Grenzflächen in dephasierten balancierten Steady-State Free Precession Sequences zu reduzieren.

Diese Aufgabe wird gelöst durch den jeweiligen Gegenstand der unabhängigen Ansprüche. Vorteilhafte Weiterbildungen und bevorzugte Ausführungsformen sind Gegenstand der abhängigen Ansprüche.

Ein erster Aspekt der Erfindung betrifft ein Verfahren zur Erfassung von Magnetresonanzbilddaten eines Untersuchungsobjektes durch eine Magnetresonanzvorrichtung. In einem ersten Schritt des Verfahrens ist vorgesehen, dass durch die Magnetresonanzvorrichtung eine balancierte Steady-State Free Precession Sequence durchgeführt wird. Bei der Steady-State Free Precession Sequence handelt es sich um eine Magnetresonanzbildgebungssequenz, welche derart beschaffen ist, dass eine Phasenkohärenz einer transversalen Magnetisierung zwischen den Anregungszeitpunkten zum Teil aufrechterhalten ist. Bei der balancierten SSFP ist die Sequenz derart ausgelegt, dass alle Gradientendephasierungsmomente vor dem nächsten Erregungsimpuls ausgeglichen werden. Es ist vorgesehen, dass durch die Sequenz mittels eines Erregungsimpulses gewöhnlich ein Phasenfortschritt von 180 Grad pro Repetitionszeit durch die Magnetresonanzvorrichtung bewirkt wird. Es ist vorgesehen, dass in der bSSFP-Sequenz ein Whitemarker-Gradient bereitgestellt wird, um eine durch ein magnetfeldveränderndes Objekt in dem Untersuchungsobjekt hervorgerufene lokale Dephasierung zumindest teilweise auszugleichen. Mit anderen Worten wird durch die Magnetresonanzvorrichtung der Whitemarker-Gradient erzeugt, durch welchen lokale Dephasierungen, die durch das magnetfeldverändernde Objekt hervorgerufen werden, abgeschwächt werden.

Durch die Magnetresonanzvorrichtung erfolgt ein Erfassen von Bilddaten des Untersuchungsobjekts durch die Magnetresonanzvorrichtung zu einer vorbestimmten Echozeit. Die Echozeit kann beispielsweise eine halbe Repetitionszeit betragen. Mit anderen Worten kann in einer zeitlichen Mitte der Repetitionszeit durch die Magnetresonanzvorrichtung die Erfassung der Bilddaten des Untersuchungsobjekts durchgeführt werden. Die Echozeit kann auch von der halben Repetitionszeit um beispielsweise maximal 20%, 15%, 10% oder 5% der Repetitionszeit abweichen.

Es ist vorgesehen, dass durch die Magnetresonanzvorrichtung eine Anpassung einer Phasenentwicklung zwischen einer Phase einer Magnetisierung eines ersten Stoffs und einer Phase einer Magnetisierung eines zweiten Stoffs durchgeführt wird. Der erste Stoff und der zweite Stoff können in dem Untersuchungsobjekt eine Grenzfläche bilden. Mit anderen Worten können die Stoffe unterschiedliche Resonanzfrequenzen aufweisen, wodurch sich die Phasen der Stoffe unterschiedlich über eine Zeit ändern können. Aufgrund der unterschiedlichen Änderungen der Phasen kann es zu einer Phasenentwicklung zwischen den beiden Phasen kommen. Die Phasenentwicklung kann derart beschaffen sein, dass die Phase des ersten Stoffs und die Phase des zweiten Stoffs zu einem Zeitpunkt der vorbestimmten Echozeit eine Phasendifferenz von 180 Grad aufweisen können. Dadurch können sich Signale, die aus der Phase der Protonen des ersten Stoffs resultieren und Signale, die aus Protonen des zweiten Stoffs resultieren destruktiv überlagern, wodurch eine Signalintensität eines Signals aus einem Volumenelement, welches beide Protonen aufweist, reduziert oder ausgelöscht sein kann.

Der Whitemarker-Gradient kann zu einer Änderung der Phasen der zwei Stoffe in dem Volumenelement führen. Dadurch kann die Phasendifferenz zu der vorbestimmten Echozeit von 180 Grad abweichen. Ein Umfang einer destruktiven Überlagerung der Signale wird somit für den Zeitpunkt reduziert. Dies führt zu einer Erhöhung der Signalintensität in dem Volumenelement, in welchem sich sowohl der erste Stoff als auch der zweite Stoff befindet.

Diese Erhöhung der Signalintensität durch den Whitemarker-Gradienten kann jedoch an Grenzflächen unerwünscht sein. In diesem Fall ist es erforderlich, die Signalintensität in den besagten Volumenelementen zu reduzieren.

Die Erfindung sieht vor, die Phasenentwicklung zwischen der Phase der Magnetisierung des ersten Stoffs und der Phase der Magnetisierung des zweiten Stoffs derart zu verändern, dass die Phasen, ohne Einwirkung des Whitemarker-Gradienten, gleichphasig zu der vorgegebenen Echozeit sind. Zu diesem Zweck kann durch die Magnetresonanzvorrichtung die Phasenentwicklung derart angepasst werden, dass die Phasenentwicklung vor der Wirkung des Whitemarker-Gradienten eine gleichphasige Ausrichtung der Magnetisierung des ersten Stoffs und der Magnetisierung des zweiten Stoffs an der Grenzfläche aufweist. Im Allgemeinen kommt es ohne einem Vorliegen des Whitemarker-Gradienten bei einer gleichphasigen Ausrichtung der Stoffe zu einer Addition der Signalintensitäten in dem Volumenelement, welches beide Stoffe aufweist und somit eine Grenzfläche der beiden Stoffe abbildet. Aufgrund des Vorliegens des Whitemarker-Gradienten kommt es jedoch in der beschriebenen Situation zu einer Schwächung des Signals in dem besagten Volumenelement der Grenzfläche.

Aufgrund der Anpassung der Phasenlage zwischen den Phasen der beiden Stoffe kommt es somit bei einer Bereitstellung des Whitemarker-Gradienten zu einer Abschwächung einer Signalintensität. Ohne die Beeinflussung der Phasenlage würde es dagegen zu einer Erhöhung der Signalintensität kommen.

Durch die Erfindung ergibt sich der Vorteil, dass durch den Whitemarker-Gradienten eine Erhöhung der Signalintensität in einem Bereich eines magnetfeldverändernden Objektes ermöglicht wird, ohne gleichzeitig eine Signalintensität an einer Grenzfläche zwischen den zwei Stoffen zu erhöhen.

Die Erfindung umfasst auch Weiterbildungen, durch die sich weitere Vorteile ergeben.

Eine Weiterbildung der Erfindung sieht vor, dass das Anpassen der Phasenentwicklung ein Einstellen einer Scannerfrequenz der BSSFP-Sequenz umfasst. Die Scannerfrequenz wird dabei durch die Magnetresonanzvorrichtung derart gewählt, dass sich diese in einer Mitte zwischen einer Larmor-Frequenz des ersten Stoffs und einer Larmor-Frequenz des zweiten Stoffs befindet. Die Scannerfrequenz fScanner ergibt sich gemäß der Formel fScanner = 0.5* (fLarmor,m1 + fLarmor,m2) aus der Larmorfrequenz des ersten Stoffs fLarmor,m1 und der Larmorfrequenz des zweiten Stoffs fLarmor,m2. Mit anderen Worten weist die Scannerfrequenz einen Wert auf, welcher sich durch eine Addition der Larmor-Frequenz des ersten Stoffs mit der Larmor-Frequenz des zweiten Stoffs und einer anschließenden Teilung der Summe durch 2 ergibt. Die Scannerfrequenz liegt somit in dem arithmetischen Mittel zwischen der Larmor-Frequenz des ersten Stoffs und der Larmor-Frequenz des zweiten Stoffs. Durch die Anpassung der Scannerfrequenz wird das Untersuchungsobjekt somit nicht, wie üblich mit der Larmor-Frequenz des Wassers angeregt, sondern mit einer davon abweichenden Scannerfrequenz. Die Änderung der Scannerfrequenz führt dazu, dass die zeitliche Phasenänderung der Magnetisierung des ersten Stoffs identisch zu der zeitlichen Phasenänderung der Magnetisierung des zweiten Stoffs ist. Die Richtungen der zeitlichen Phasenänderungen der beiden Stoffe sind jedoch entgegengesetzt. Die Magnetisierung entlang der Grenzfläche wird somit gleichphasig refokussiert. Aufgrund der gleichphasigen Refokussierung der Protonen beider Stoffe führt der angelegte Whitemarker-Gradient an der Grenzfläche zu einer Dephasierung anstatt zu einer Rephasierung der Magnetisierung, wodurch eine Signalintensität entlang der Grenzfläche durch den Whitemarker-Gradienten reduziert wird.

Eine Weiterbildung der Erfindung sieht vor, dass das Anpassen der Phasenentwicklung ein Bereitstellen eines zusätzlichen Phasenfortschritts pro Repetitionszeit der bSSFP-Sequenz umfasst, wobei für den zusätzlichen Phasenfortschritt der bSSFP-Sequenz gilt: ((fLarmor,m1 - fLarmor,m2) / 2) x TR x 360 Grad. Mit anderen Worten ist es vorgesehen, dass die Larmor-Frequenz von Wasser als Scanfrequenz zur Anregung während der Sequenz verwendet wird. Die Anpassung der Phasenentwicklung erfolgt dabei dadurch, dass während der jeweiligen Repetitionszeit zusätzlich zu der Bereitstellung des gewöhnlichen Phasenfortschritts pro Repetitionszeit ein weiterer Phasenfortschritt bereitgestellt wird, welcher sich aus der genannten Formel ergibt. Mit anderen Worten wird der Wert des gewöhnlichen Phasenfortschritts um einen zusätzlichen Wert des weiteren Phasenfortschritts ergänzt. Der zusätzliche Phasenfortschritt hängt dabei von der Larmor-Frequenz des ersten Stoffs und der Larmor-Frequenz des zweiten Stoffs ab. Es ist somit vorgesehen, weiterhin die Larmor-Frequenz des ersten Stoffs als die Scanfrequenz zu verwenden und anstatt der Anpassung der Scanfrequenz den Phasenzyklus der Anregungspulse zu verändern, um die Bandstruktur der Sequenz relativ zu den Resonanzfrequenzen des ersten Stoffs und des zweiten Stoffs zu verschieben. Gewöhnlicherweise ist es vorgesehen, dass die Sequenz einen Phasenfortschritt von 180 Grad pro Repetitionszeit bewirkt, damit der erste Stoff eine Resonanz in einem Zentrum des zentralen Bandes aufweist, wobei angenommen wird, dass die Scanfrequenz mit der Larmor-Frequenz des ersten Stoffs übereinstimmt. Durch das Einstellen der Scanfrequenz auf die Resonanzfrequenz des ersten Stoffes und das Bereitstellen des zusätzlichen Phasenfortschrittes zwischen den Pulsen werden die Resonanzfrequenzen symmetrisch in der Bandstruktur platziert.

Eine Weiterbildung der Erfindung sieht vor, dass der erste Stoff Fett und der zweite Stoff Wasser ist. Mit anderen Worten ist das Verfahren dazu vorgesehen, eine Signalintensität an einer Grenzfläche zwischen Fett und Wasser zu reduzieren.

Die Kombination ist insbesondere für Gewebegrenzflächen relevant, weil Grenzflächen zwischen Fettgewebe und sonstigem Gewebe durch die Protonen des Fetts und der Protonen des Wassers des weiteren Gewebes in einem gemeinsamen Volumenelement ungewünscht hohe Signalintensitäten hervorrufen können. Grenzflächen zwischen Fettgewebe und sonstigem Gewebe sind insbesondere in biologischen Untersuchungen relevant.

Eine Weiterbildung der Erfindung sieht vor, dass der erste Stoff Silikon und der zweite Stoff Wasser ist. Mit anderen Worten ist das Verfahren dazu vorgesehen, eine Signalintensität an einer Grenzfläche zwischen Wasser und Silikon zu reduzieren. Die Kombination ist insbesondere für Grenzflächen zwischen Gewebe und Implantaten relevant.

Für Anwendungsfälle oder Anwendungssituationen, die sich bei dem Verfahren ergeben können und die hier nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Ein zweiter Aspekt der Erfindung betrifft eine Magnetresonanzvorrichtung zur Erfassung von Magnetresonanzbilddaten eines Untersuchungsobjekts. Die Magnetresonanzvorrichtung ist dazu eingerichtet, eine balanced Steady-State Free Precession Sequence mit einem gewöhnlichen Phasenfortschritt von 180 Grad pro Repetitionszeit bereitzustellen. Die Magnetresonanzvorrichtung ist dazu eingerichtet, in der Sequenz einen Whitemarker-Gradienten bereitzustellen, um eine durch ein magnetfeldveränderndes Objekt in dem Untersuchungsobjekt hervorgerufene Dephasierung zumindest teilweise auszugleichen. Die Magnetresonanzvorrichtung ist dazu eingerichtet, Bilddaten des Untersuchungsobjekts zu einer vorbestimmten Echozeit zu erfassen. Es ist vorgesehen, dass die Magnetresonanzvorrichtung dazu eingerichtet ist, eine Phasenentwicklung zwischen einer Phase einer Magnetisierung eines ersten Stoffs und einer Phase einer Magnetisierung eines zweiten Stoffs, welche eine Grenzfläche in dem Untersuchungsobjekt bilden, in der balanced Steady-State Free Precession Sequence anzupassen. Es ist vorgesehen, dass die Anpassung der Phasenentwicklung vor der Wirkung des Whitemarker-Gradienten eine gleichphasige Ausrichtung einer Magnetisierung des ersten Stoffs und des zweiten Stoffs an der Grenzfläche zu der Echozeit bewirkt.

Weitere Ausführungsformen der erfindungsgemäßen Magnetresonanzvorrichtung folgen aus den verschiedenen Ausführungsformen des erfindungsgemäßen Verfahrens.

Entsprechend einem dritten Aspekt der Erfindung wird ein Computerprogramm bereitgestellt, welches direkt in einen Speicher einer Steuereinrichtung einer oben genannten Magnetresonanzvorrichtung ladbar ist, mit Programm-Mitteln, um die Schritte des oben erwähnten Verfahrens auszuführen, wenn das Programm in der Steuereinrichtung der Magnetresonanzvorrichtung ausgeführt wird. Gleichermaßen wird ein elektronisch lesbarer Datenträger mit darauf gespeicherten elektronisch lesbaren Steuerinformationen bereitgestellt, welche zumindest ein Computerprogramm obiger Art umfassen und derart ausgestaltet sind, dass sie bei Verwendung des Datenträgers in einer Steuereinrichtung der oben genannten Magnetresonanzvorrichtung ein Verfahren nach obiger Art durchführen. Das System kann insbesondere einen Computer, einen Mikrocontroller oder einen integrierten Schaltkreis umfassen. Alternativ kann die Magnetresonanzvorrichtung einen realen oder virtuellen Verbund (d.h. Cluster) von Computern umfassen. In diesem Ausführungsbeispiel umfasst die Magnetresonanzvorrichtung einen Prozessor beziehungsweise eine Recheneinheit. Die Recheneinheit kann Hardware-Elemente und/oder Software-Elemente aufweisen, beispielsweise einen Mikroprozessor oder ein sogenanntes FPGA (Field Programmable Gate Array). Eine Speichereinheit kann als nicht dauerhafter Arbeitsspeicher (RAM) oder als dauerhafter Massenspeicher (Festplatte, USB-Stick, SD-Karte (SSD)) realisiert sein.

Unter einer Recheneinheit kann insbesondere ein Datenverarbeitungsgerät verstanden werden, die einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere Einchipsysteme, SoC (englisch: "system on a chip"). Die Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere digitale Signalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer Festwertspeicher, EPROM (englisch: "erasable read-only memory"), als elektrisch löschbarer Festwertspeicher, EEPROM (englisch: "electrically erasable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCRAM (englisch: "phase-change random access memory"), ausgestaltet sein.

Die wenigstens eine Auswerteeinheit, die Steuereinrichtung und/oder die Messeinheit der erfindungsgemäßen Magnetresonanzvorrichtung kann eine oder mehrere Recheneinheiten gemäß diesem Verständnis beinhalten oder eine oder mehrere Recheneinheiten der Magnetresonanzvorrichtung können die wenigstens eine Auswerteeinheit, die Steuereinrichtung und/oder die Messeinheit beinhalten.

Ist im Rahmen der vorliegenden Offenbarung die Rede davon, dass eine Komponente der erfindungsgemäßen Magnetresonanzvorrichtung, insbesondere die Steuereinrichtung, die Messeinheit oder wenigstens eine Auswerteeinheit der Magnetresonanzvorrichtung dazu eingerichtet, ausgebildet, ausgelegt, oder dergleichen ist, eine bestimmte Funktion auszuführen oder zu realisieren, eine bestimmte Wirkung zu erzielen oder einem bestimmten Zweck zu dienen, so kann dies derart verstanden werden, dass die Komponente, über die prinzipielle oder theoretische Verwendbarkeit oder Eignung der Komponente für diese Funktion, Wirkung oder diesen Zweck hinaus, durch eine entsprechende Anpassung, Programmierung, physische Ausgestaltung und so weiter konkret und tatsächlich dazu in der Lage ist, die Funktion auszuführen oder zu realisieren, die Wirkung zu erzielen oder dem Zweck zu dienen.

Eine Verbindung zweier elektrischer oder elektronischer Komponenten kann, sofern nicht ausdrücklich anders angegeben, derart verstanden werden, dass eine elektrische Verbindung zwischen den Komponenten besteht oder durch Betätigung eines oder mehrerer Schaltelemente hergestellt werden kann. Insbesondere können die Komponenten direkt oder indirekt miteinander verbunden sein, sofern nicht anders angegeben. Dabei kann eine direkte Verbindung so verstanden werden, dass außer dem optionalen einen oder mehreren Schaltelementen keine weiteren elektrischen oder elektronischen Komponenten zwischen den Komponenten angeordnet sind, während eine indirekte Verbindung so verstanden werden kann, dass zusätzlich zu dem optionalen einen oder mehreren Schaltelementen eine oder mehrere weitere elektrische oder elektronische Komponenten, etwa Widerstände, Kondensatoren, Spulen und so weiter, zwischen den Komponenten angeordnet sind.

Weitere Ausführungsformen des erfindungsgemäßen Computerprogramms folgen aus den verschiedenen Ausführungsformen des erfindungsgemäßen Verfahrens sowie des erfindungsgemäßen Magnetresonanzvorrichtung.

Ein vierter Aspekt der Erfindung betrifft einen elektronisch lesbareren Datenträger mit darauf gespeicherten elektronisch lesbaren Steuerinformationen , welche zumindest ein Computerprogramm gemäß dem dritten Aspekt der Erfindung umfassen und derart ausgestaltet sind, dass sie bei Verwendung des Datenträgers in einer Steuereinrichtung eines einer Magnetresonanzvorrichtung gemäß dem zweiten Erfindungsaspekt ein Verfahren gemäß dem ersten Erfindungsaspekt durchführen. Weitere Ausführungsformen des erfindungsgemäßen elektronisch lesbareren Datenträgers folgen aus den verschiedenen Ausführungsformen des erfindungsgemäßen Verfahrens, der erfindungsgemäßen Magnetresonanzvorrichtung sowie des erfindungsgemäßen Computerprogramms.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren gezeigten Merkmale und Merkmalskombinationen können nicht nur in der jeweils angegebenen Kombination, sondern auch in anderen Kombinationen von der Erfindung umfasst sein. Es können insbesondere auch Ausführungen und Merkmalskombinationen von der Erfindung umfasst sein, die nicht alle Merkmale eines ursprünglich formulierten Anspruchs aufweisen. Es können darüber hinaus Ausführungen und Merkmalskombinationen von der Erfindung umfasst, die über die in den Rückbezügen der Ansprüche dargelegten Merkmalskombinationen hinausgehen oder von diesen abweichen.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt. In den Figuren zeigen:

FIG 1   eine schematische Darstellung einer beispielhaften Ausführungsform einer erfindungsgemäßen Magnetresonanzvorrichtung;

FIG 2   eine schematische Darstellung einer beispielhaften Ausführungsform eines Ablaufs eines erfindungsgemäßen Verfahrens;

FIG 3   eine schematische Darstellung eines beispielhaften Auslesegradienten einer dephasierten bSSFP-Sequenz;

FIG 4   eine schematische Darstellung einer beispielhaften bSSFP-Signalbildung in der Nähe eines magnetfeldverändernden Objekts;

FIG 5   eine schematische Darstellung einer beispielhaften bSSFP-Signalbildung um eine paramagnetische Nadel für bSSFP-basierte Sequenzen ohne WM-Gradient

FIG 6   eine schematische Darstellung einer beispielhaften bSSFP-Signalbildung um eine paramagnetische Nadel für bSSFP-basierte Sequenzen mit WM-Gradient

FIG 7   eine schematische Darstellung einer beispielhaften Analyse der Signalbildung im dephasierten bSSFP an Fettgewebe-Grenzflächen.

FIG 8   eine schematische Darstellung einer beispielhaften Analyse der Signalbildung im dephasierten bSSFP an Fettgewebe-Grenzflächen.

FIG 9   eine schematische Darstellung einer beispielhaften Simulation eines virtuellen menschlichen Phantoms, das eine virtuelle paramagnetische Nadel enthält.

FIG 10   eine schematische Darstellung einer beispielhaften dephasierten bSSFP-Sequenz.

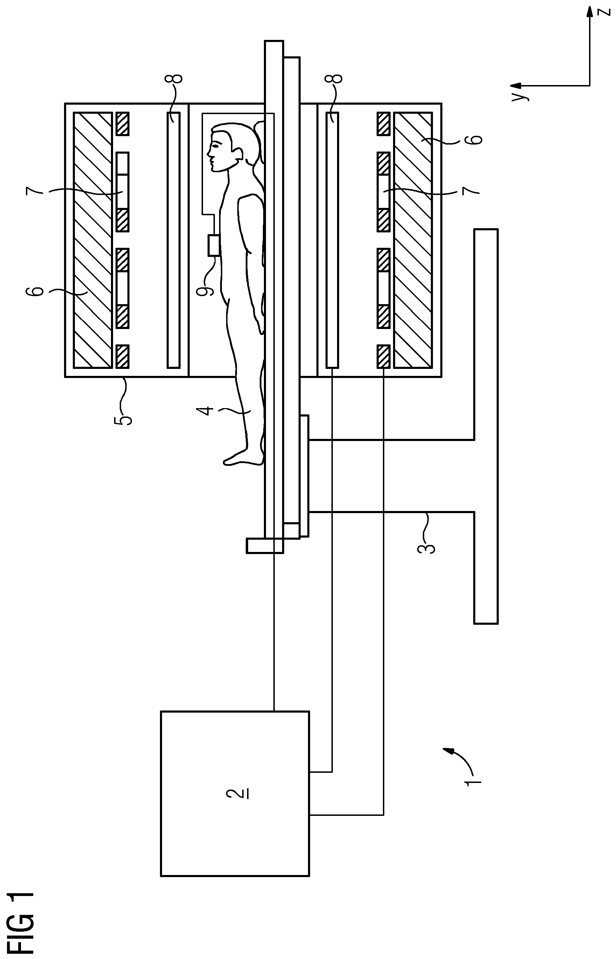

In FIG 1 ist schematisch eine beispielhafte Ausführungsform einer erfindungsgemäßen Magnetresonanzvorrichtung 1 dargestellt.

Die Magnetresonanzvorrichtung 1 umfasst einen Kernspintomographen 5 mit einem Feldmagneten 6, der ein statisches Magnetfeld zur Ausrichtung von Kernspins eines Untersuchungsobjekts 4, zum Beispiel eines Patienten, in einem Bildgebungsbereich erzeugt. Der Bildgebungsbereich ist durch ein äußerst homogenes statisches Magnetfeld gekennzeichnet, wobei sich die Homogenität insbesondere auf die Magnetfeldstärke beziehungsweise deren Amplitude bezieht. Der Bildgebungsbereich befindet sich in einem Patiententunnel, der sich in einer Längsrichtung Z durch den Kernspintomographen 5 erstreckt. Der Feldmagnet 6 kann beispielsweise ein supraleitender Magnet sein, der Magnetfelder mit einer magnetischen Flussdichte von bis zu 3 Tesla oder mehr erzeugen kann. Für geringere Feldstärken können jedoch auch Permanentmagnete oder Elektromagnete mit normalleitenden Spulen verwendet werden. Ein Patiententisch 3 kann innerhalb des Patiententunnels beweglich sein.

Weiterhin umfasst der Kernspintomograph 5 eine Gradientenspulenanordnung 7 mit mehreren Gradientenspulen, die dazu dienen, dem statischen Magnetfeld Gradientenfelder, also ortsabhängige Magnetfelder, in den drei Raumrichtungen zur räumlichen Differenzierung der abgetasteten Bildbereiche im Bildgebungsbereich zu überlagern. Die Gradientenspulen der Gradientenspulenanordnung 7 können zum Beispiel als Spulen aus normalleitenden Drähten ausgebildet sein, die zum Beispiel zueinander orthogonale Felder oder Feldgradienten im Bildgebungsbereich erzeugen können.

Der Kernspintomograph 5 umfasst eine Sendespulenanordnung, die beispielsweise eine Körperspule 8 als Sendeantenne umfassen kann, die dazu ausgebildet ist, ein Hochfrequenzsignal in den Bildgebungsbereich abzustrahlen. Die Körperspule 8 kann daher als HF-Sendespulenanordnung der Magnetresonanzvorrichtung 1 verstanden werden oder als Teil der HF-Sendespulenanordnung. Die Körperspule 8 kann in einigen Ausführungsformen auch dazu verwendet werden, resonante MR-Signale zu empfangen, die von dem Untersuchungsobjekt 4 ausgesendet werden. In diesem Fall kann die Körperspule 8 auch als Teil einer Signalerfassungsvorrichtung der Magnetresonanzvorrichtung 1 betrachtet werden. Optional umfasst die Signalerfassungsvorrichtung eine lokale Spule 9, die in unmittelbarer Nähe des Untersuchungsobjekts 4, zum Beispiel an dem Untersuchungsobjekt 4 oder in dem Patiententisch 3, angeordnet sein kann. Die lokale Spule 9 kann alternativ oder zusätzlich zur Körperspule 8 als Empfangsspule beziehungsweise Empfangsantenne dienen.

Die Magnetresonanzvorrichtung 1 umfasst auch eine Steuereinrichtung 2. Die Steuereinrichtung 2 kann eine Empfangssteuereinheit umfassen, die als Teil der Signalerfassungsvorrichtung angesehen werden kann und mit der Körperspule 8 und/oder der lokalen Spule 9 verbunden ist. In Abhängigkeit von den erfassten MR-Signalen kann die Empfangssteuereinheit, die einen Analog-Digital-Wandler, ADC englisch: "analog-to-digital converter" umfassen kann, entsprechende MR-Daten, insbesondere im k-Raum, erzeugen. Eine Recheneinheit des Steuer- und Rechensystems kann die MR-Daten auswerten und zum Beispiel eine Bildrekonstruktion zur Generierung einer MRT-Aufnahme 10 des Untersuchungsobjektes 4 durchführen.

Die Steuereinrichtung 2 umfasst eine Sendesteuereinheit, die mit der Körperspule 8 verbunden ist und diese zur Erzeugung von HF-Impulsen, wie Anregungsimpulsen und/oder Refokussierungsimpulsen, steuert. Die Steuereinrichtung 2 umfasst eine Gradientensteuereinheit, die mit der Gradientenspulenanordnung 7 verbunden ist und diese steuert, um Schichtselektionsgradienten, Gradienten für die Frequenz- und/oder Phasencodierung und/oder Auslesegradienten zu schalten.

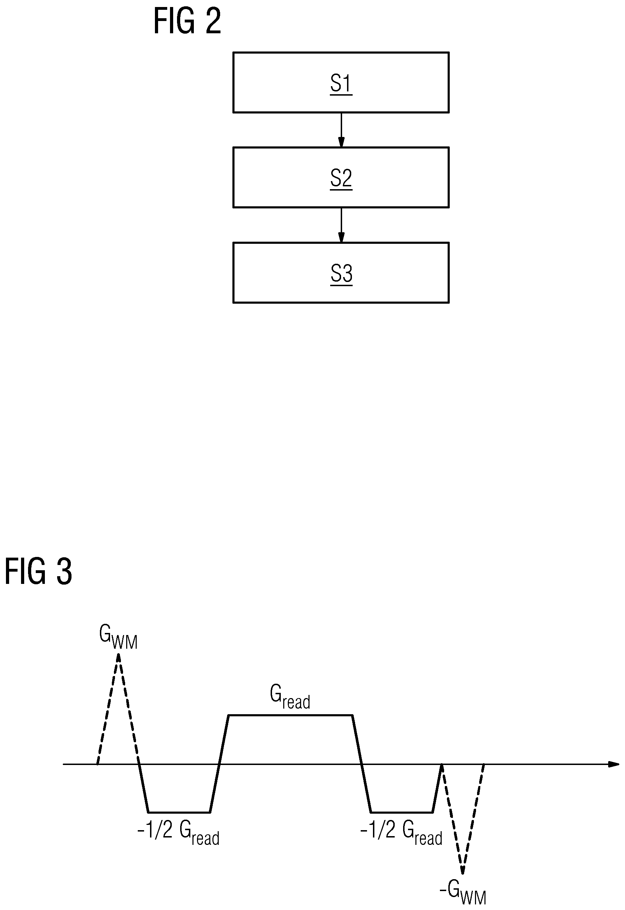

Es wird darauf hingewiesen, dass die beschriebene Struktur der Steuereinrichtung 2 nur ein nicht begrenztes Beispiel darstellt. Die verschiedenen erforderlichen Aufgaben und Funktionen können auch anders und/oder auf verschiedene Steuereinheiten und/oder andere Recheneinheiten verteilt sein. Die Magnetresonanzvorrichtung 1 ist insbesondere in der Lage, ein Verfahren zur MRT gemäß der Erfindung durchzuführen FIG 2 zeigt eine schematische Darstellung einer beispielhaften Ausführungsform eines Ablaufs eines erfindungsgemäßen Verfahrens;
Das Verfahren kann zur Generierung einer MRT-Aufnahme 10 des Untersuchungsobjektes 4 durch eine Magnetresonanzvorrichtung 1 vorgesehen sein.

In einem erste Schritt S1 können durch eine Steuereinrichtung 2 der Magnetresonanzvorrichtung 1 Steuerdaten zum Ansteuern der Magnetresonanzvorrichtung 1 übermittelt werden um die Magnetresonanzvorrichtung 1 zur Durchführung einer Balanced Steady-State Free Precession Sequenz anzusteuern.

Die Magnetresonanzvorrichtung 1 kann die Balanced Steady-State Free Precession Sequenz mit einem gewöhnlichen Phasenfortschritt $\Phi$ von 180 Grad pro Repetitionszeit TR durchführen, wobei in der Balanced Steady-State Free Precession Sequenz ein Whitemarker-Gradient GWM durch die Magnetresonanzvorrichtung 1 bereitgestellt wird, um eine durch ein magnetfeldveränderndes Objekt in dem Untersuchungsobjekt 4 hervorgerufene Dephasierung zumindest teilweise auszugleichen.

Ein zweiter Schritt S2 kann ein Anpassen einer Phasenentwicklung zwischen einer Phase einer Magnetisierung eines ersten Stoffs und einer Phase einer Magnetisierung eines zweiten Stoffs, welche eine Grenzfläche in dem Untersuchungsobjekt 4 bilden, in der Balanced Steady-State Free Precession Sequenz durch die Magnetresonanzvorrichtung **1,** wobei durch die Anpassung der Phasenentwicklung vor der Wirkung des Whitemarker-Gradienten GWM eine gleichphasige Ausrichtung einer Magnetisierung des ersten Stoffs m1 und des zweiten Stoffs m2 an der Grenzfläche zu der Echozeit TE bewirkt wird.

Ein dritter Schritt S3 des Verfahrens kann ein Erfassen von Bilddaten des Untersuchungsobjekts 4 durch die Magnetresonanzvorrichtung 1 zu einer Echozeit TE umfassen. Die Echozeit TE kann eine halbe Repetitionszeit TR betragen oder von dieser um einen vorbestimmten Wert abweichen. Die Bilddaten können durch die Steuereinrichtung 2 zur Generierung einer MRT-Aufnahme 10 des Untersuchungsobjektes 4 ausgewertet werden.

FIG 3 zeigt eine schematische Darstellung eines beispielhaften Auslesegradienten Gread einer dephasierten bSSFP-Sequenz.

Balanced Steady State Free Precession (bSSFP) Imaging beschreibt einen spezifischen Signalbildungsmechanismus in der MRT. Dieser Signalbildungsmechanismus ist dadurch gekennzeichnet, dass alle Magnetfeldgradienten Gx, Gy, Gz am Ende jeder Repetitionszeit TR ausgeglichen sind und eine kohärente Phasenbeziehung zwischen aufeinanderfolgenden Anregungspulsen RF besteht. Whitemarker-Gradienten GWM können in Gradientenechosequenzen eingeführt werden, nicht aber in Spinechosequenzen, da der gewöhnliche Phasenfortschritt $\Phi$ um 180 Grad die eingeführte Dephasierung umkehren würden. Obwohl die bSSFP-Sequenz dem Typ der Spin-Echo-Sequenz zugeordnet werden kann, ist eine Kombination der Sequenz mit Whitemarker-Gradienten GWM möglich, da die Magnetisierung zum Zeitpunkt einer halben Repetitionszeit entweder bei 0 oder 180 Grad rephasiert, abhängig vom Phasenfortschritt der selbigen während einer Repetitionszeit. Feldinhomogenitäten können somit zu einer gegenphasigen Magnetisierung innerhalb eines Voxels führen und somit zu einer Signalauslöschung, der mithilfe eines Whitemarker-Gradienten entgegengewirkt werden kann.

Gezeigt ist der Verlauf des Auslesegradienten Gread in der dephasierten bSSFP-Sequenz. Alle Gradientenmomente werden vor dem Ende der Repetitionszeit TR ausgeglichen, um eine bSSFP-Signalbildung zu erreichen. Ein zusätzlicher Whitemarker-Gradient GWM führt eine zusätzliche Phase ein. In Gebieten mit homogener Suszeptibilität verursacht der Whitemarker-Gradient GWM einen Signalverlust aufgrund der eingeführten Dephasierung. In der Nähe von magnetfeldverändernden Objektes kann der Whitemarker-Gradient GWM einer Signalreduktion, die durch einen Suszeptibilitätsunterschied verursachten lokalen Störgradienten GS induziert wird, entgegenwirken und somit eine Signalintensität eines Signals erhöhen oder sogar wiederherstellen.

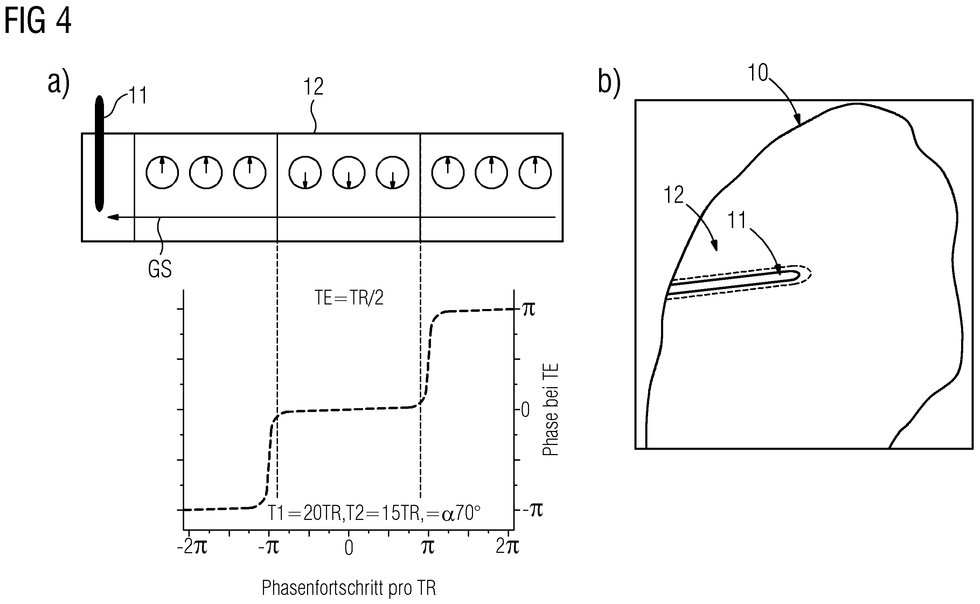

FIG 4 zeigt eine schematische Darstellung einer beispielhaften bSSFP-Signalbildung in der Nähe eines magnetfeldverändernden Objekts;

Unter FIG 4 a ist ein Schnitt durch ein Untersuchungsobjekt 4 schematisch dargestellt. In einem Gewebe 12 des Untersuchungsobjekts 4 ist eine paramagnetische Nadel 11 als magnetfeldveränderndes Objekt an einer linken Seite der MRT Aufnahme 10 platziert. Die Nadel 11 induziert einen lokalen Störgradienten GS im Magnetfeld, der bewirkt, dass sich ein Magnetfeld im Gewebe 12 um die Nadel 11 herum verändert. Dies führt zu einer räumlich variierenden Phasenentwicklung während der Repetitionszeit TR. Aufgrund der bSSFP-Signalbildung wird die Magnetisierung bei TR/2 mit einer Phase von entweder 0° oder 180° refokussiert, je nach der lokalen Phasenentwicklung. Die Kreise mit den Zeigern stellen die Phase der lokalen Magnetisierung der Protonen des Gewebes 12 zur Echozeit TE dar. Das Diagramm zeigt die Phase bei TE gegen den Phasenfortschritt pro TR.

Unter (b) ist eine MRT Aufnahme 10 eines Untersuchungsobjekts 4 um die Nadel 11 gezeigt, welche den durch dephasiertes bSSFP erzeugten Kontrast aufweist. Die Nadel 11 kann in das umliegende Gewebe 12 des Untersuchungsobjekts 4 eingeführt sein. Das Objekt ist durch ein dunkles Artefakt gekennzeichnet, das auf einen Signalverlust zurückzuführen ist, der durch die Refokussierung der Intravoxel Magnetisierung bei TE mit wechselnder Phase, wie in (a) gezeigt, verursacht wird, wodurch es zu einer destruktiven Überlagerung von Signalanteilen kommt.

Aufgrund der Magnetfeldstörung, die um die Nadel 11 herum induziert wird, und der daraus resultierenden Magnetisierungsdephasierung führt das inhärente Signalbildungsverhalten der Sequenz zu einer alternierenden Phase bei der Echozeit TE in der Magnetisierung des Gewebes 12 um die Nadel 11 herum. Der suszeptibilitätsinduzierte Störgradient GS bewirkt, dass die Magnetisierung eine räumlich abhängige Resonanzfrequenz (Larmor-Frequenz) hat, die folglich dazu führt, dass die Magnetisierung während der Repetitionszeit TR eine räumlich abhängige Phase akkumuliert. Abhängig von dieser akkumulierten Phase wird das Echo entweder bei 0 Grad oder 180 Grad gebildet. Unter a ist die charakteristische Bandstruktur abgebildet. Geschieht dies im selben Voxel, hebt sich die gegenphasige Magnetisierung auf und das Signal geht verloren, was in der MRT Aufnahme 10 zu einem dunklen Bildartefakt in der Nähe der Nadel 11 führt.

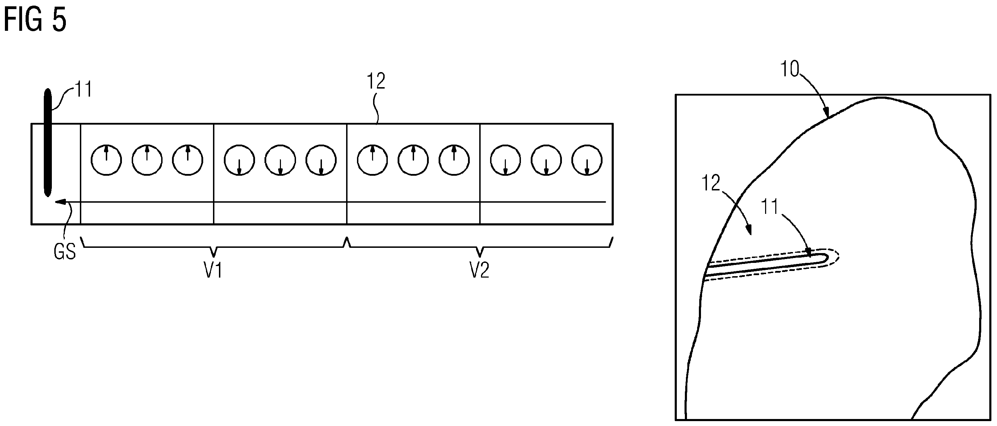

FIG 5 zeigt eine schematische Darstellung einer beispielhaften bSSFP-Signalbildung um eine paramagnetische Nadel 11 für bSSFP-basierte Sequenzen ohne Whitemarker-Gradient GWM.

Gezeigt ist eine Signalbildung um eine paramagnetische Nadel 11 für bSSFP-basierte Sequenzen ohne Whitemarker-Gradient GWM. Ähnlich wie in FIG 4 ist ein Schnitt durch ein Gewebe 12 mit einer Nadel 11 schematisch dargestellt. Durch die Nadel 11 wird eine lokal alternierende Phase bei der Echozeit TE in dem Gewebe 12 induziert, dargestellt durch die Kreise mit den Zeigern. Dies manifestiert sich als Signalverlust um die Nadel 11 herum, wenn sich die alternierende Phase der Magnetisierung innerhalb desselben Voxels V1, V2 aufhebt. Der Bildkontrast für diesen Fall ist in der MRT Aufnahme 10 des Untersuchungsobjektes 4 gezeigt.

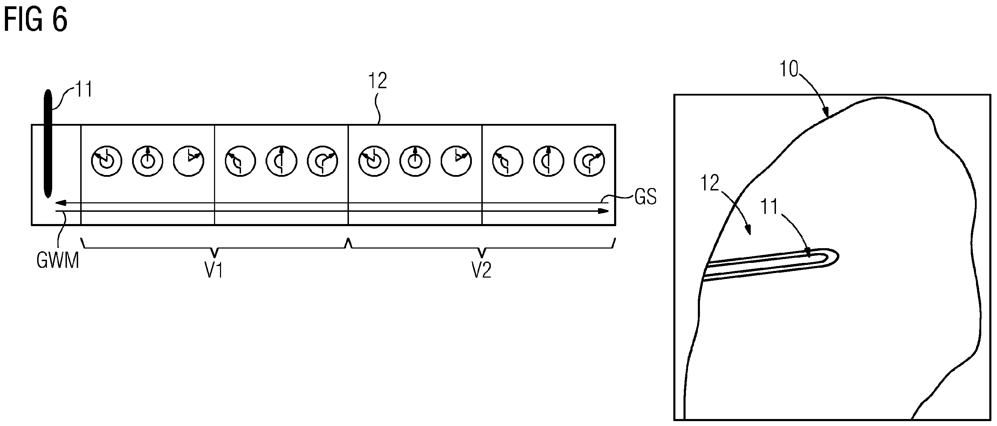

FIG 6 zeigt eine schematische Darstellung einer beispielhaften bSSFP-Signalbildung um eine paramagnetische Nadel 11 für bSSFP-basierte Sequenzen mit Whitemarker-Gradient GWM.

Gezeigt ist eine Signalbildung um eine paramagnetische Nadel 11 für bSSFP-basierte Sequenzen mit Whitemarker-Gradient GWM. Die Anwendung eines Whitemarker-Gradient GWM, kann die Phase der Protonen innerhalb der Voxel V1, V2 teilweise neu fokussieren und somit das Signal wiederherstellen. Es bildet sich ein typischer WM-Kontrast in der MRT Aufnahme 10. Der Bildkontrast diesen Fall ist in der Abbildung des Untersuchungsobjektes 4 gezeigt.

Die dephasierte MRT ermöglicht es, einen Bildkontrast zu erzeugen, der magnetfeldverändernde Objekte wie paramagnetische interventionelle Objekte, z. B. Biopsienadeln 11 oder Katheter, hervorhebt. Dies wird z. B. durch die Anwendung zusätzlicher so genannter "White Marker (WM)"-Gradienten oder Whitemarker-Gradienten GWM erreicht. Objekte mit einer anderen Suszeptibilität als das Gewebe 12 stören lokal das Magnetfeld und verursachen lokale Störgradienten GS im Magnetfeld. Diese führen zu einem Signalverlust um das Objekt herum aufgrund der Dephasierung der lokalen Magnetisierung. Das Anlegen der zusätzlichen Whitemarker-Gradienten GWM verursacht eine Dephasierung der Magnetisierung in Gewebe 12 mit homogenem Magnetfeld B0, kann aber der durch das magnetfeldverändernde Objekt induzierten Dephasierung teilweise entgegenwirken. Dies führt zur Bildung eines Kontrasts, der durch signalintensive Bereiche um das magnetfeldverändernde Objekt und einen dunklen dephasierten Hintergrund in größerer Entfernung vom Störer gekennzeichnet ist.

Dem Signalverlust in der Nähe magnetfeldverändernder Objekte kann mit einem Whitemarker-Gradienten gegengewirkt werden. Die Einführung des zusätzlichen Whitemarker-Gradient GWM bewirkt eine zumindest teilweise erfolgende Umphasung der Magnetisierung um das magnetfeldverändernde Objekt. Dephasiertes bSSFP wurde in der Vergangenheit zur Lokalisierung von Objekten in der interventionellen MRT verwendet. Da bSSFP im Allgemeinen ein höheres Signal-Rausch-Verhältnis als GRE hat und die Magnetisierungsrephasierung um magnetfeldverändernde Objekte aufgrund des symmetrischen Wechselphasenverhaltens nicht von der Gradientenpolarität abhängt, kann es hinsichtlich dieser Aspekte als vorteilhaft gegenüber dephasiertem GRE angesehen werden.

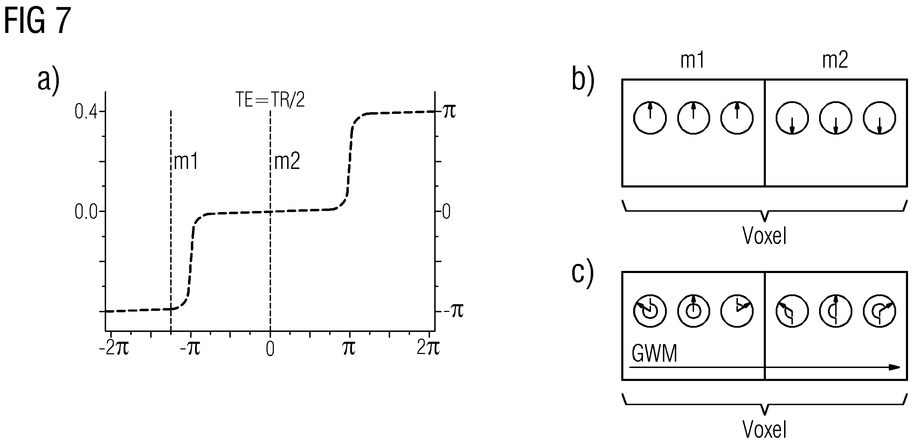

FIG 7 zeigt eine schematische Darstellung einer beispielhaften Analyse der Signalbildung im dephasierten bSSFP an Grenzflächen.

FIG 7 b,c zeigt eine Grenzfläche, an welcher ein erster Stoff m1 an einen zweiten Stoff angrenzt. Ein Voxel Voxel kann einem Volumenelement zugeordnet sein, in welchem sich beide Stoffe m1, m2 befinden können. Bei den Stoffen m1, m2 kann es sich beispielsweise um Fett und angrenzendes Gewebe 12 handeln. Wenn sich während der Repetitionszeit TR eine Phasendifferenz phi zwischen Fett und angrenzendem Gewebe 12 (z. **B.** Muskel) entwickelt, **d. h.** im Bereich (2*n-1)*pi < phi < 2*n*pi mit n natürlich, wird die Magnetisierung bei der Echozeit TE mit einer Phasendifferenz von 180 Grad über die Gewebeschnittstelle refokussiert (FIG 7 a). Das Diagramm zeigt die Phase bei TE gegen den Phasenfortschritt pro TR. Dies kann zu einem Signalabfall aufgrund von Phasenauslöschung in dem Voxel Voxel führen, das die Gewebegrenze enthält (FIG 7 b). Die Anwendung des Whitemarker-Gradienten GWM kann die Magnetisierung an der Gewebeschnittstelle teilweise umphasieren, was zu einem Anstieg des Signals führt (FIG 7 c). Da die Resonanzfrequenzen von Fett und Wasser durch eine chemische Verschiebung von etwa 3,5 ppm voneinander getrennt sind, ist es möglich, dass die Magnetisierung in den verschiedenen Gewebetypen ein Echo mit jeweils entgegengesetzter Phase bildet, da die relative Phasenverschiebung zwischen den beiden Gewebetypen bewirkt, dass sie in unterschiedliche Phasenbänder fallen. Dies geschieht für alle Werte der Repetitionszeiten TR, die zu einer Phasendifferenz zwischen Fett und angrenzendem Gewebe 12 (z. **B.** Muskel) von (2*n-1)*pi < phi < 2*n*pi führen, wobei n natürlich ist. Der Effekt führt zu einer erhöhten Signalintensität an den Grenzflächen des Fettgewebes 12, da der Whitemarker-Gradient GWM an diesen Grenzflächen einen Rephasierungseffekt hat, der mit dem Effekt in der Nähe des Metallgeräts vergleichbar ist.

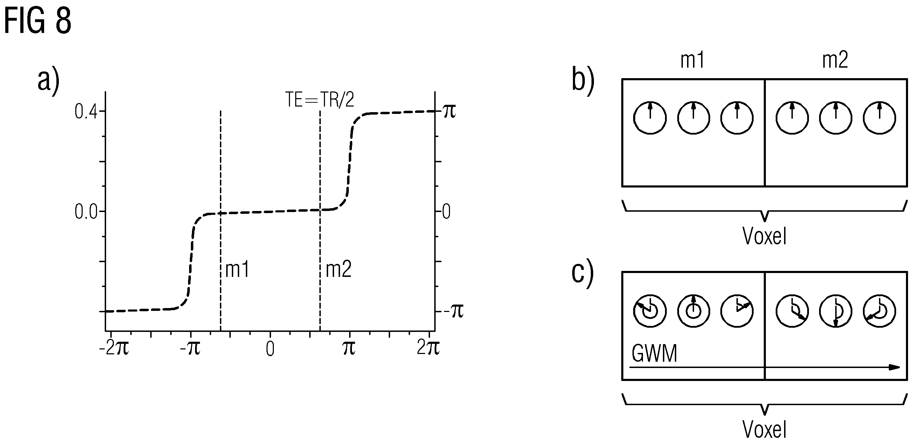

FIG 8 zeigt eine schematische Darstellung einer beispielhaften Analyse der Signalbildung im dephasierten bSSFP an Fettgewebe 12-Grenzflächen.

Durch die Anpassung kann die Sequenz so angepasst werden, dass die Phasenentwicklung für die Magnetisierung des Fettgewebes 12 und des angrenzenden Gewebes 12 absichtlich so verändert ist, dass die Magnetisierung an den Grenzflächen des Fettgewebes 12 mit der gleichen Phase refokussiert wird.

Um dies zu erreichen kann beispielsweise eine Scannerfrequenz **d. h.** die Frequenz, auf die der Empfänger/-Sender abgestimmt ist bewusst so angepasst sein, dass sie fScanner = 0,5*(fLarmor,m1 + fLarmor,m2) beträgt. Die Lage der Larmorfrequenzen der Stoffe m1 und m2 in der Bandstruktur ist in FIG 8 a gezeigt. Das Diagramm zeigt die Phase bei TE gegen den Phasenfortschritt pro TR. Durch eine solche Wahl der Scannerfrequenz anstelle der standardmäßigen Wahl der Wasserfrequenz als Scannerfrequenz hat die Phasenverschiebung für die Magnetisierung im ersten Stoff den gleichen Wert mit entgegengesetztem Vorzeichen wie für die Magnetisierung aus dem zweiten Stoff, und die Magnetisierung an den Grenzflächen wird mit der gleichen Phase refokussiert. Folglich hat der Whitemarker-Gradient GWM einen Dephasierungs- statt eines Rephasierungseffekts auf die Magnetisierung und die Signalstärke wird unterdrückt.

Durch Verschieben der Scannerfrequenz auf fScanner = 0,5* (fLarmor,m1 + fLarmor,m2) hat beispielsweise die Phasenverschiebung für die Magnetisierung im Fettgewebe 13 den gleichen Wert mit entgegengesetztem Vorzeichen wie für die Magnetisierung aus dem anderen Gewebe 12. Dadurch wird die Magnetisierung der Protonen über die Grenzfläche in dem Voxel Voxel mit der gleichen Phase refokussiert (FIG 8 b). Folglich hat der Whitemarker-Gradient GWM einen Dephasierungseffekt statt eines Rephasierungseffekts auf die Magnetisierung und die Signalstärke des Signals des gezeigten Voxels wird unterdrückt (FIG 8 c).

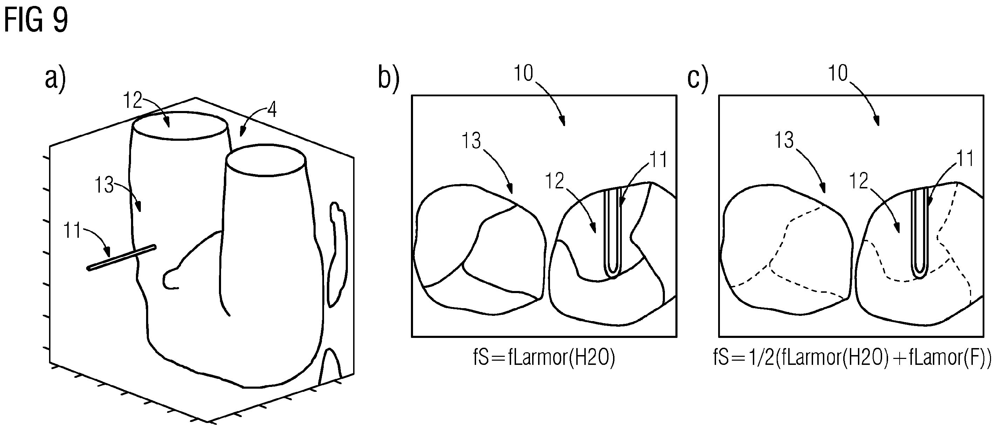

FIG 9 zeigt eine schematische Darstellung einer beispielhaften Simulation eines virtuellen menschlichen Phantoms, das eine virtuelle paramagnetische Nadel 11 enthält.

Unter Verwendung eines virtuellen menschlichen Phantoms, das eine virtuelle paramagnetische Nadel 11 enthält, wurden Bloch-Simulationen durchgeführt, um einen phasenverschobenen bSSFP-Kontrast zu erzeugen, wie er in der Literatur für die Nadelverfolgung verwendet wurde.

Mit einer Sequenz, die auf dem dephasierten bSSFP-Ausleseschema aus FIG 3 basiert, wurden zwei Bilder erzeugt. FIG 9 b zeigt den Kontrast mit der Scannerfrequenz fScanner, die auf die Larmor-Frequenz des Wassers zentriert ist. FIG 9 c zeigt den Kontrast mit fScanner = 0,5* (fLarmor,Fett + fLarmor,Wasser). Dies führt dazu, dass die Magnetisierung an den Grenzflächen des Fettgewebes 12 mit der gleichen Phase bei TE refokussiert wird. Der Whitemarker-Gradient GWM führt zu einer homogenen Dephasierung über die Voxel V1, V2 an der Fettgewebe 12-Grenzfläche, und es wird keine zusätzliche Signalintensität verursacht.

Unter FIG 9 a ist das virtuelle menschliche Phantom gezeigt. Ein transversaler Schnitt aus dem simulierten Datensatz, der die Nadel 11 enthält, ist in FIG 9 b dargestellt. Es ist zu erkennen, wie das Kontrastverfahren die Umgebung der Nadel 11 hervorhebt, was erwünscht ist. Aber auch an den Grenzflächen zum Fettgewebe 13 ist ein hohes Signal zu sehen, was nicht erwünscht ist. Ein weiterer transversaler Schnitt aus dem simulierten Datensatz, der die Nadel 11 enthält, ist in FIG 9 c dargestellt. Die Scannerfrequenz wurde absichtlich von fScanner = fLarmor,m1 auf fScanner = 0,5* (fLarmor,m1 + fLarmor,m2) geändert. Dies führt dazu, dass die Magnetisierung im Fett und im angrenzenden Gewebe 12 mit der gleichen Phase bei TE refokussiert wird, so dass der Whitemarker-Gradient GWM das Signal an den Grenzflächen aufhebt und die Intensität unterdrückt. Ein verbleibendes Signal an den Grenzflächen kann auf einen partiellen Volumeneffekt zurückzuführen sein. Folglich ist die Nadel 11 deutlicher sichtbar.

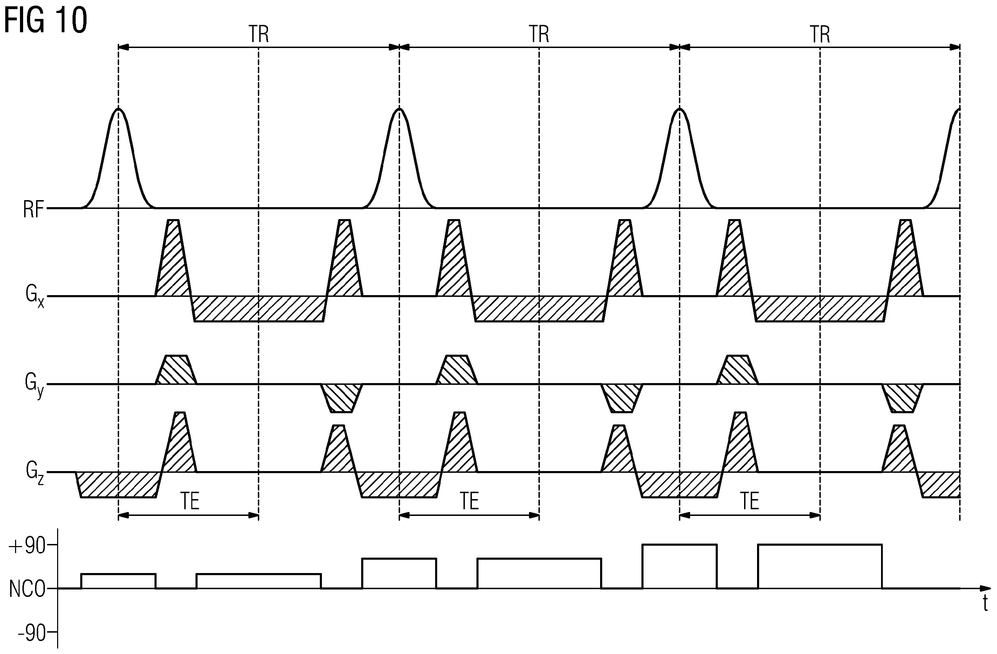

FIG 10 zeigt eine schematische Darstellung einer beispielhaften dephasierten bSSFP-Sequenz mit einem zusätzlichen Phasenfortschritt Φ. Damit eine dephasierte bSSFP bereitgestellt ist, kann im Gegensatz zu einer normalen bSSFP ein zusätzliches GWM-Moment eingeführt werden. Dies kann beispielsweise dadurch geschehen, dass ein Rephasierungs-Lobe des Schichtwahlgradienten Gz nicht genau 1/2x so groß ist wie der Schichtwahlgradient, der während des rf-Pulses appliziert wird. Wählt man beispielsweise ein größeres Moment, wie in Fig. 10 eingezeichnet, so muss dieses aber auch wieder ausgeglichen werden am Ende von TR durch einen Schichtwahl-Prephaser-Lobe.

Im Stand der Technik ist es verbreitet, Die NCO-Phase (Numerically Controlled Oscillator) um 180 Grad zu verändern, sodass diese beispielsweise zwischen +90 Grad und -90 Grad alterniert. In dem beschriebenen Verfahren kann die Änderung der NCO-Phase pro Repetitionszeit von 180 Grad abweichen, sodass diese nicht zwischen +90 Grad und -90 Grad alterniert.

Anstatt die Scannerfrequenz zu ändern, kann es vorgesehen sein, stattdessen den Phasenzyklus der bSSFP-HF-Impulse ändern, um das gleiche Ziel der Verschiebung der bSSFP-Bandstruktur relativ zu den Fett- und Wasserresonanzen zu erreichen.

Eine Standard-bSSFP-Sequenz verwendet eine Phasenverschiebung von 180°/TR, um die Wasserresonanz in der Mitte des zentralen Bandes zu platzieren, unter der Annahme, dass die Scannerfrequenz auf die Wasserfrequenz abgestimmt ist.

Wird die Scannerfrequenz auf die Wasserresonanz eingestellt, welches standardmäßig der Fall ist bei einer Standard-Frequenzkalibrierung, und wendet einen zusätzliche Phasenfortschritt von ((fLarmor,fat - fLarmor,water)/2) * TR * 360° von Puls zu Puls an, so werden die Resonanzen der beiden Stoffe symmetrisch in die Bandenstruktur eingefügt.

Bei dephasiertem bSSFP kann ein unerwünschtes Signal von Fettgewebe-Grenzflächen 13 stammen, was auf den oben beschriebenen Signalbildungsmechanismus bei der bSSFP-Bildgebung zurückzuführen ist. Diese zusätzliche Signalgröße kann mit dem vorgestellten Ansatz unterdrückt werden.

Dadurch ergeben sich mehrere Vorteile. Es kann ein deutlicherer Bildkontrast ermöglicht werden, wodurch eine Sichtbarkeit des magnetfeldverändernden Objekts verbessert werden kann. Dies ist **z. B.** für den Anwendungsfall der Objektelokalisierung von Vorteil, insbesondere wenn entweder nur beeinträchtigte Bilddaten zur schnellen unterabgetasteten Bildakquisition verwendet werden oder maschinelles Lernen zur automatischen Nadellokalisierung verwendet werden soll. Die zusätzliche Größe, die durch die Fettgewebegrenzflächen entsteht, erhöht die Komplexität des Bildes und folglich die Komplexität der Lokalisierungsaufgabe und wirkt sich daher negativ auf die Lokalisierungsgenauigkeit aus, wenn sie nicht unterdrückt wird.

Die Lösung ermöglicht eine volle Flexibilität bei der Wahl der Repetitionszeit TR, da die akkumulierte Phasendifferenz zwischen Fettgewebe 13 und anderem Gewebe 12 durch die bereitgestellten Ansätze irrelevant wird.

In einer vollständig ausgeglichenen Sequenz würde die Repetitionszeit TR für eine robuste Signalerzeugung gewählt werden. Es müsste also eine Repetitionszeit TR gewählt werden, welche die Fett- und Wasserresonanzen von den dunklen bSSFP-Sperrbändern entfernt. Dies ist jedoch für "dephasiertes bSSFP" nicht erforderlich. In Bereichen, die vom magnetfeldverändernden Objekt entfernt sind, soll das Signal ohnehin mit Hilfe der Whitemarker-Gradienten GWM unterdrückt werden, so dass es keine Rolle spielt, ob die Stopp-Bänder getroffen werden. In der Nähe der magnetfeldverändernden Objekte werden aufgrund der großen B0-Inhomogenität viele Stopp- und Durchlassbänder in ein Voxel V1, V2 fallen, wobei die Repetitionszeit TR keine Rolle spielt, da dies immer einen Intra-Voxel V1, V2-Mittelungseffekt über die Bandstruktur in den für das WM-Signal relevanten Bereichen um das Objekt erzeugt.

Es bleibt somit eine Flexibilität bei einer Wahl der Repetitionszeit TR erhalten. Eine Verwendung einer Fettunterdrückungstechnik könnte dazu führen, dass das phasenverschobene Signal an den Grenzflächen von Wasser und Fett verschwindet. Dies wäre jedoch kontraproduktiv, wenn das Objekt Fettgewebe 13 durchquert, da hier kein WM-Kontrast entstehen kann, wenn das Fettsignal insgesamt unterdrückt wird.

Die vorgeschlagenen Lösungen ermöglichen eine wesentlich elegantere Lösung.

Es ist anzunehmen, dass der Effekt der unerwünschten Signalrephasierung auch bei der dephasierten GRE-Bildgebung eine Rolle spielen kann. Im Gegensatz zur dephasierten bSSFP mit der vorgeschlagenen Methode kann dieses unerwünschte Signal jedoch nicht unterdrückt werden, so dass die dephasierte bSSFP mit der vorgeschlagenen Methode in dieser Hinsicht theoretisch die bessere Technik ist.

Durch diese Erfindung wird eine deutliche Verbesserung des Kontrasts erreichen, der durch Dephased bSSFP bei Grenzflächen zwischen Fettgewebe 13 und angrenzendem Gewebe 12 erzeugt wird, die normalerweise in der Nähe der Wasserresonanzfrequenz schwingen.

**Patentansprüche**

1. Verfahren zur Erfassung von Magnetresonanz-Bilddaten eines Untersuchungsobjekts (4) durch eine Magnetresonanzvorrichtung (1),

umfassend die Schritte:

- Durchführen einer Balanced Steady-State Free Precession Sequenz mit einem gewöhnlichen Phasenfortschritt (Φ) von 180 Grad pro Repetitionszeit (TR) durch die Magnetresonanzvorrichtung (1), wobei in der Balanced Steady-State Free Precession Sequenz ein Whitemarker-Gradient (GWM) bereitgestellt wird, um eine durch ein magnetfeldveränderndes Objekt in dem Untersuchungsobjekt (4) hervorgerufene Dephasierung zumindest teilweise auszugleichen,
- Erfassen von Bilddaten des Untersuchungsobjekts (4) durch die Magnetresonanzvorrichtung (1) zu einer Echozeit (TE), **dadurch gekennzeichnet, dass**

das Verfahren den Schritt umfasst:

- Anpassen einer Phasenentwicklung zwischen einer Phase einer Magnetisierung eines ersten Stoffs (m1) und einer Phase einer Magnetisierung eines zweiten Stoffs (m2), welche eine Grenzfläche in dem Untersuchungsobjekt (4) bilden, in der Balanced Steady-State Free Precession Sequenz durch die Magnetresonanzvorrichtung (1), wobei durch die Anpassung der Phasenentwicklung vor der Wirkung des Whitemarker-Gradienten (GWM) eine gleichphasige Ausrichtung einer Magnetisierung des ersten Stoffs (m1) und des zweiten Stoffs (m2) an der Grenzfläche zu der Echozeit (TE) bewirkt wird.

2. Verfahren nach Anspruch 1,
   **dadurch gekennzeichnet, dass**
   das Anpassen der Phasenentwicklung ein Einstellen einer Scannerfrequenz der Balanced Steady-State Free Precession Sequenz umfasst, wobei die Scannerfrequenz in einer Mitte zwischen einer Larmorfrequenz des ersten Stoffs (m1) (fLarmor,m1) und einer Larmorfrequenz des zweiten Stoffs (m2) (fLarmor,m2) liegt.

3. Verfahren nach Anspruch 1,
   **dadurch gekennzeichnet, dass**
   das Anpassen der Phasenentwicklung ein Bereitstellen eines zusätzlichen Phasenfortschritts (Φ) pro Repetitionszeit (TR) der Balanced Steady-State Free Precession Sequenz umfasst, wobei für den zusätzlichen Phasenfortschritt (Φ1) der Balanced Steady-State Free Precession Sequenz gilt:

```
((fLarmor,m1 - fLarmor,m2)/2) * TR  * 360°
```

4. Verfahren nach einem der vorherigen Ansprüche,
   **dadurch gekennzeichnet, dass** der erste Stoff (m1) Fett und der zweite Stoff (m2) Wasser ist.

5. Verfahren nach einem der Ansprüche 1 bis 3,
   **dadurch gekennzeichnet, dass** der erste Stoff (m1) Silikon und der zweite Stoff (m2) Wasser ist.

6. Magnetresonanzvorrichtung (1) zur Erfassung von Magnetresonanz-Bilddaten eines Untersuchungsobjekts (4), wobei

   die Magnetresonanzvorrichtung (1) dazu eingerichtet ist,

   - eine Balanced Steady-State Free Precession Sequenz mit einem gewöhnlichen Phasenfortschritt (Φ) von 180 Grad pro Repetitionszeit (TR) bereitzustellen,
   - in der Balanced Steady-State Free Precession Sequenz ein Whitemarker-Gradient (GWM) bereitzustellen, um eine durch ein magnetfeldveränderndes Objekt in dem Untersuchungsobjekt (4) hervorgerufene Dephasierung zumindest teilweise auszugleichen,
   - Bilddaten des Untersuchungsobjekts (4) zu einer Echozeit (TE) zu erfassen,

   **dadurch gekennzeichnet, dass**
   die Magnetresonanzvorrichtung (1) dazu eingerichtet ist,

   - eine Phasenentwicklung zwischen einer Phase einer Magnetisierung eines ersten Stoffs (m1) und einer Phase einer Magnetisierung eines zweiten Stoffs (m2), welche eine Grenzfläche in dem Untersuchungsobjekt (4) bilden, in der Balanced Steady-State Free Precession Sequenz anzupassen, wobei

die Anpassung der Phasenentwicklung vor der Wirkung des Whitemarker-Gradienten (GWM) eine gleichphasige Ausrichtung einer Magnetisierung des ersten Stoffs (m1) und des zweiten Stoffs (m2) an der Grenzfläche zu der Echozeit (TE) bewirkt.

7. Computerprogramm, welches direkt in einen Speicher einer Steuereinrichtung (2) einer Magnetresonanzvorrichtung (1) nach Anspruch 5 ladbar ist, mit Programm-Mitteln, um die Schritte des Verfahrens nach einem der Ansprüche 1 bis 4 auszuführen, wenn das Programm in der Steuereinrichtung (2) der Magnetresonanzvorrichtung (1) ausgeführt wird.

8. Elektronisch lesbarer Datenträger mit darauf gespeicherten elektronisch lesbaren Steuerinformationen, welche zumindest ein Computerprogramm nach Anspruch 7 umfassen und derart ausgestaltet sind, dass sie bei Verwendung des Datenträgers in einer Steuereinrichtung (2) einer Magnetresonanzvorrichtung nach Anspruch 6 ein Verfahren nach einem der Ansprüche 1 bis 5 durchführen.

**Claims**

1. Method for capturing magnetic resonance image data of an object under examination (4) using a magnetic resonance apparatus (1),

   comprising the steps:

   - performance of a balanced steady-state free precession sequence with a nominal phase progress ($\Phi$) of 180 degrees per repetition time (TR) using the magnetic resonance apparatus (1), wherein in the balanced steady-state free precession sequence a white-marker gradient (GWM) is provided in order at least partially to balance a dephasing caused by a magnetic-field-changing object in the object under examination (4),
   - capture of image data of the object under examination (4) using the magnetic resonance apparatus (1) at an echo time (TE),

   **characterised in that**
   the method comprises the step:

   - adjustment of a phase development between a phase of a magnetisation of a first material (m1) and a phase of a magnetisation of a second material (m2), which form an interface in the object under examination (4), in the balanced steady-state free precession sequence using the magnetic resonance apparatus (1), wherein thanks to the adjustment of the phase development prior to the effect of the white-marker gradient (GWM) a co-phasal alignment of a magnetisation of the first material (m1) and of the second material (m2) at the interface is effected at the echo time (TE).

2. Method according to claim 1,
   **characterised in that**
   the adjustment of the phase development comprises setting a scanner frequency of the balanced steady-state free precession sequence, wherein the scanner frequency lies in a centre between a Larmor frequency of the first material (m1) (fLarmor,m1) and a Larmor frequency of the second material (m2) (fLarmor,m2).

3. Method according to claim 1,
   **characterised in that**
   the adjustment of the phase development comprises a provision of an additional phase progress ($\Phi$) per repetition time (TR) of the balanced steady-state free precession sequence, wherein the following applies for the additional phase progress ($\Phi1$) of the balanced steady-state free precession sequence:

$$((fLarmor,m1 - fLarmor,m2)/2) * TR * 360°$$

4. Method according to one of the preceding claims, **characterised in that** the first material (m1) is fat and the second material (m2) is water.

5. Method according to one of claims 1 to 3,
   **characterised in that** the first material (m1) is silicone and the second material (m2) is water.

6. Magnetic resonance apparatus (1) for capturing magnetic resonance image data of an object under examination (4), wherein

   the magnetic resonance apparatus (1) is designed

   - to provide a balanced steady-state free precession sequence with a nominal phase progress ($\varphi$) of 180 degrees per repetition time (TR),
   - in the balanced steady-state free precession sequence to provide a white-marker gradient (GWM), in order at least partially to balance a dephasing caused by a magnetic-field-changing object in the object under examination (4),
   - to capture image data of the object under examination (4) at an echo time (TE),

   **characterised in that**
   the magnetic resonance apparatus (1) is designed

   - to adjust a phase development between a phase of a magnetisation of a first material (m1) and a phase of a magnetisation of a second material (m2), which form an interface in the object under examination (4), in the balanced steady-state free precession sequence, wherein

   the adjustment of the phase development prior to the effect of the white-marker gradient (GWM) effects a co-phasal alignment of a magnetisation of the first material (m1) and of the second material (m2) at the interface at the echo time (TE).

7. Computer program, which can be loaded directly into a memory of a control facility (2) of a magnetic resonance apparatus (1) according to claim 5, with program means in order to execute the steps of the method according to one of claims 1 to 4, if the program is executed in the control facility (2) of the magnetic resonance apparatus (1).

8. Electronically readable data storage medium with electronically readable control information stored thereon, which comprises at least one computer program according to claim 7 and is configured so that when the data storage medium is used in a control facility (2) of a magnetic resonance apparatus according to claim 6 it performs a method according to one of claims 1 to 5.

## Revendications

1. Procédé de saisie de données d'image de résonance magnétique d'un objet (4) à examiner par une installation (1) de résonance magnétique,

   comprenant les stades :

   - exécution d'une séquence balanced steady-state free precession avec un progrès ($\Phi$) de phase habituelle de 180 degrés par temps (TR) de répétition par l'installation (1) de résonance magnétique, dans lequel dans la séquence balanced steady-state free precession on met à disposition un gradient (GWM) de whitemarker, afin de compenser au moins en partie un déphasage provoqué par un objet modifiant le champ magnétique dans l'objet (4) à examiner,
   - saisie de données d'image de l'objet (4) à examiner par l'installation (1) de résonance magnétique à un temps (TE) d'écho,

   **caractérisé en ce que**
   le procédé comprend le stade :

   - adaptation d'un développement de phase entre une phase d'une magnétisation d'une première substance (m1) et une phase d'une magnétisation d'une deuxième substance (m2), qui forment une surface limite dans l'objet (4) à examiner, dans la séquence balanced steady-state free precession par l'installation (1) de résonance magnétique, dans lequel, par l'adaptation du développement de phase avant l'effet du gradient (GWM) de whitemarker, on provoque une orientation de même phase d'une magnétisation de la première matière (m1) et de la deuxième matière (m2) à la surface limite au temps (TE) d'écho.

2. Procédé suivant la revendication 1,
   **caractérisé en ce que**
   l'adaptation du développement de phase comprend un réglage d'une fréquence de scanner de la séquence balanced steady-state free precession, dans lequel la fréquence de scanner se trouve en un milieu entre une fréquence de Larmor de la première matière (m1) (fLarmor, m1) et une fréquence de Larmor de la deuxième matière (m2) (fLarmor, m2).

3. Procédé suivant la revendication 1,
   **caractérisé en ce que**
   l'adaptation du développement de phase comprend une mise à disposition d'un progrès ($\Phi$) de phase supplémentaire par temps (TR) de répétition de la séquence balanced steady-state free precession, dans lequel pour le progrès ($\Phi 1$) de phase supplémentaire de la séquence balanced steady-state free precession, on a :

$$((fLarmor, m1 - fLarmor, m2) / 2) * TR * 360°$$

4. Procédé suivant l'une des revendications précédentes,
   **caractérisé en ce que** la première matière (m1) est de la graisse et la deuxième matière (m2) de l'eau.

5. Procédé suivant l'une des revendications 1 à 3,
   **caractérisé en ce que** la première matière (m1) est une silicone et la deuxième matière (m2) de l'eau.

6. Installation (1) de résonance magnétique pour la saisie de données d'image de résonance magnétique d'un objet (4) à examiner, dans lequel l'installation (1) de résonance magnétique est agencée pour

   - mettre à disposition une séquence balanced steady-state free precession ayant un progrès ($\Phi$) de phase habituelle de 180 degrés par temps (TR) de répétition,
   - mettre à disposition dans la séquence balanced steady-state free precession, un gradient (GWM) de whitemarker, afin de compenser au moins en partie un déphasage provoqué par un objet modifiant le champ magnétique dans l'objet (4) à examiner,
   - saisir des données d'image de l'objet (4) à examiner à un temps (TE) d'écho,

   **caractérisé en ce que**
   l'installation (1) de résonance magnétique est agencée pour

   - adapter dans la séquence balanced steady-state free precession un développement de phase entre une phase d'une magnétisation d'une première matière (m1) et une phase d'une magnétisation d'une deuxième matière (m2), qui forment une surface limite dans l'objet (4) à examiner, dans lequel l'adaptation du développement de phase avant l'effet du gradient (GWM) de whitemarker provoque une orientation de même phase d'une magnétisation de la première matière (m1) et de la deuxième matière (m2) à la surface limite au temps (TE) d'écho.

7. Programme d'ordinateur, qui peut être chargé directement dans la mémoire d'un dispositif (2) de commande d'une installation (1) de résonance magnétique suivant la revendication 5, comprenant des moyens de programme pour exécuter les stades du procédé suivant l'une des revendications 1 à 4, lorsque le programme est exécuté dans le dispositif (2) de commande de l'installation (1) de résonance magnétique.

8. Support de données déchiffrable électroniquement sur lequel sont mises en mémoire des informations de commande déchiffrables électroniquement, qui comprennent au moins un programme d'ordinateur suivant la revendication 7 et qui sont conformées, de manière à ce qu'elles exécutent, lors de l'utilisation du support de données dans un dispositif (2) de commande d'une installation de résonance magnétique suivant la revendication 6, un procédé suivant l'une des revendications 1 à 5.

## FIG 1

## FIG 2

S1

S2

S3

## FIG 3

$G_{WM}$

$G_{read}$

$-1/2\ G_{read}$

$-1/2\ G_{read}$

$-G_{WM}$

FIG 4

a)

11

12

GS

TE=TR/2

Phase bei TE

$\pi$

0

$-\pi$

T1=20TR,T2=15TR,=$\alpha$70°

$-2\pi$   $-\pi$   0   $\pi$   $2\pi$

Phasenfortschritt pro TR

b)

10

12

11

EP 4 332 602 B1

FIG 5

FIG 6

FIG 7

a)

b) m1    m2

Voxel

c)

GWM

Voxel

# FIG 8

a)

b)

c)

EP 4 332 602 B1

# FIG 9

a)

b)

$fS = fLarmor(H2O)$

c)

$fS = 1/2(fLarmor(H2O) + fLamor(F))$

EP 4 332 602 B1

FIG 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **SEPPENWOOLDE** ; **SEPPENWOOLDE, JAN-HENRY** ; **VIERGEVER, MAX A.** ; **BAKKER, CHRIS JG. et al.** Passive tracking exploiting local signal conservation: the white marker phenomenon.. *Magnetic Resonance in Medicine: An Official Journal of the International Society for Magnetic Resonance in Medicine*, 2003, vol. 50 (4), 784-790

- **KOKTZOGLOU et al.** Dephased FLAPS for improved visualization of susceptibility-shifted passive devices for real-time interventional MRI. *Physics in Medicine and Biology*, 2007, vol. 52 (13), N277-N286